# EUROPÄISCHE PATENTANMELDUNG

(11) **EP 2 355 149 A2**
(43) Veröffentlichungstag der Anmeldung: **10.08.2011**
(21) Anmeldenummer: 10193055.0
(22) Anmeldetag: 30.11.2010
(51) Int. Cl.: H01L 23/473

(54) **Anordnung mit Leistungshalbleiterbaugruppen und einer Flüssigkeitskühleinrichtung**

(30) Priorität: 06.02.2010 DE 102010007086
(71) Anmelder: SEMIKRON Elektronik GmbH & Co. KG, 90431 Nürnberg (DE)
(72) Erfinder: Bogen, Ingo, 90425 Nürnberg (DE)

(57) **Zusammenfassung**

Die Anmeldung betrifft eine Anordnung mit einer Mehrzahl von Leistungshalbleiterbaugruppen und einer Flüssigkeitskühleinrichtung, wobei die Leistungshalbleiterbaugruppen auf einander gegenüberliegenden Hauptseiten dieser Flüssigkeitskühleinrichtung angeordnet sind, und die Flüssigkeitskühleinrichtung zwei Formkörper mit jeweils mindestens einer Aufnahme für die Leistungshalbleiterbaugruppen aufweist mit
einer beiden Formkörpern gemeinsamen Verteilkammer, deren Zulaufanschluss im erste Formkörper angeordnet ist;
mit einer der jeweiligen Leistungshalbleiterbaugruppe zugeordneten Kühlkammer mit einem Zulauf aus der Verteilkammer;
mit je Kühlkammer seitlich hieran angeordneten Ablaufbereich und mit einer beiden Formkörpern gemeinsamen Sammelkammer mit Ablaufanschluss.

## Beschreibung

Die Erfindung beschreibt eine Anordnung mit Leistungshalbleiterbaugruppen, wie sie beispielhaft zum Aufbau von Leistungshalbleitermodulen dienen und einer Flüssigkeitskühleinrichtung zur Kühlung der Leistungshalbleiterbauelemente als Teil der Leistungshalbleiterbaugruppen.

Gemäß dem allgemein bekannten Stand der Technik bilden Leistungshalbleitermodule und Kühleinrichtungen keine Anordnung mit besonderen gegenseitigen Formanforderungen aus. Es ist eine Vielzahl von Leistungshalbleitermodulen mit und ohne Grundplatte bekannt, die auf einer ebensolchen Vielzahl von Kühleinrichtungen beliebig angeordnet werden können. Hierzu ist es ausschließlich notwenig geeignete Verbindungsmittel sowohl an dem jeweiligen Leistungshalbleitermodul wie auch an der Kühleinrichtung vorzusehen. Allgemein bekannt hierbei sind Schraubverbindungen bei denen das Leistungshalbleitermodul mindestens eine Durchgangsöffnung und die Kühleinrichtung eine hierzu fluchtende Ausnehmung mit einem Gewinde aufweist.

Eine Ausgangspunkt der Erfindung bildet die 10 2004 021 122 A1, die eine Anordnung in Druckkontaktierung für äußerst kompakte Leistungshalbleitermodule offenbart. Diese besteht aus einer Leiterplatte, einem Leistungshalbleitermodul und einer Kühleinrichtung. Das Leistungshalbleitermodul weist ein rahmenartiges isolierendes Kunststoffgehäuse sowie einen Deckel mit Ausnehmungen auf. Die zweite Deckfläche des Gehäuses weist ein Substrat mit mindesten einer Leiterbahn und mindestens einem hierauf angeordneten und schaltungsgerecht verbundenen Leistungshalbleiterbauelement auf. Kontaktfedern, die durch die Ausnehmungen des Deckels hindurchreichen verbinden das Substrat mit der Leiterplatte. Das Gehäuse des Leistungshalbleitermoduls weist in Richtung der Leiterplatte und / oder in Richtung der Kühleinrichtung Fortsätze auf, die durch Ausnehmungen dieser hindurchragen und die eine Verbindung mit der Leiterplatte und / oder der Kühleinrichtung darstellen.

Ebenso ist aus der nicht vorveröffentlichten DE 10 2009 024 370 A1 eine Stromrichteranordnung und ein Herstellungsverfahren hierzu bekannt, wobei die Stromrichteranordnung eine Kühleinrichtung mit einem keramischen Formkörper, der eine Mehrzahl von Seitenflächen, zwei Stirnflächen und eine Mehrzahl von Kühlmedienkanälen aufweist. Hierbei reichen die Kühlmedienkanäle von der ersten zur zweiten Stirnfläche. Die jeweilige Stromrichterschaltungen weist eine Mehrzahl von, voneinander elektrischen isolierten, Leiterbahnen auf, wobei und auf mindestens einer dieser Leiterbahnen Leistungshalbeiterbauelemente angeordneten und schaltungsgerecht verbunden sind. Weiterhin sind hier zwei Stromrichterschaltungen auf unterschiedlichen Seitenflächen der Kühleinrichtung angeordnet und miteinander mittels einer flexiblen Verbindungseinrichtung verbunden.

Aus dieser Drucksschrift wie auch allgemein bekannt ist der Nachteil der ein- oder zweidimensionalen Durchströmung einer Kühleinrichtung, wobei unterschiedliche zu kühlende Komponenten abhängig von ihrer Position in Strömungsrichtung durch die Erwärmung des Kühlmediums unterschiedlich wirkungsvoll gekühlt werden.

Der Erfindung liegt die Aufgabe zugrunde eine Anordnung mit einer Mehrzahl von Leistungshalbleiterbaugruppen und einer Flüssigkeitskühleinrichtung vorzustellen, wobei diese an die Leistungshalbleiterbaugruppen konstruktiv angepasst ist und eine gleichmäßige Verteilung bei gleicher Temperatur der Kühlflüssigkeit zu allen Leistungshalbleiterbaugruppen gewährleistet.

Die Aufgabe wird erfindungsgemäß gelöst, durch eine Anordnung mit den Merkmalen des Anspruchs 1. Bevorzugte Ausführungsformen sind in den abhängigen Ansprüchen beschrieben.

Ausgangspunkt der Erfindung sind eine Mehrzahl von Leistungshalbleiterbaugruppen, die ihrerseits bevorzugt ausgebildet sind mit einem Substrat, mit auf einer ersten Hauptfläche, der Frontseite, ausgebildeten und voneinander elektrisch isolierten Leiterbahnen. Auf diesen Leiterbahnen sind eine Mehrzahl von Leistungshalbleiterbauelementen angeordnet und schaltungsgerecht miteinander, mit den Leiterbahnen und / oder den Anschlusselementen verbunden. Derartig Leistungshalbleiterbaugruppen weisen auf derjenigen den Leistungshalbleiterbauelementen abgewandten Hauptfläche, der Rückseite, ein Kühlfläche auf, die ihrerseits einen guten thermischen Kontakt zu einem Kühlmedium, im Folgenden zu einer Kühlflüssigkeit, aufweisen soll.

Erfindungsgemäß sind eine Mehrzahl von derartigen Leistungshalbleiterbaugruppen auf zwei einander gegenüberliegenden Hauptseiten einer gemeinsamen Flüssigkeitskühleinrichtung zur Kühlung angeordnet. Hierbei sollen die Substrate der Leistungshalbleiterbaugruppen in direktem Kontakt mit der Kühlflüssigkeit stehen, um eine wirkungsvolle Kühlung zu ermöglichen. Die Flüssigkeitskühleinrichtung ihrerseits weist hierzu zwei Formkörpern mit jeweils mindestens einer Aufnahme für mindestens eine zugeordnete Leistungshalbleiterbaugruppe auf.

Die beiden Formkörper der Flüssigkeitskühleinrichtung weisen eine gemeinsame Verteilkammer auf, die vorzugsweise aus je annährend gleich großen Teilkammern, einer je Formkörper gebildet wird. Der Zulaufanschluss zu dieser Verteilkammer ist im ersten Formkörper, vorzugsweise an einer Seitenfläche, angeordnet.

Von dieser Verteilkammer ausgehend reichen Zuläufe in beiden Formkörpern zu Kühlkammern, die jeweils einer Leistungshalbleiterbaugruppe zugeordnet sind. Hierbei bildet die Substratseite der Leistungshalbleiterbaugruppe, die in der zugeordneten Aufnahme angeordnet ist, eine Begrenzung der Kühlkammer aus, wodurch die Rückseite des Substrats direkt mit der Kühlflüssigkeit in thermischen Kontakt steht und somit die Wärmeabfuhr aus der Leistungshalbleiterbaugruppe sehr effizient erfolgen kann.

Vorteilhafterweise weist die jeweilige Kühlkammer eine im Wesentlichen rechteckige Grundform auf, wobei der jeweilige Zulauf zu dieser Kühlkammer aus der Verteilkammer mittig in der Grundfläche der Kühlkammer gegenüberliegend dem zugeordneten Leistungshalbleiterbaugruppe angeordnet ist.

Seitlich im Randbereich der jeweiligen Kühlkammer ist zum Abtransport der Kühlflüssigkeit ein Ablaufbereich ausgebildet, der von der Kühlkammer vorzugsweise durch eine sich von der Grundfläche der Kühlkammer in Richtung der Leistungshalbleiterbaugruppe erstreckende Wandung getrennt ist. Hierdurch bildet der Ablaufbereich über der Wandung einen Überlaufbereich aus, indem die Kühlflüssigkeit über die Wandung, die nicht bis an die Leistungshalbleiterbaugruppe heranragt, aus der Kühlkammer heraus abfließt. Durch den vorzugsweise mittigen Zulauf und den, vorzugsweise umlaufenden, seitlich vorgesehenen Ablauf der Kühlflüssigkeit wird die Leistungshalbleiterbaugruppe ausgehend von einem zentralen Punkt homogen gekühlt.

Der jeweilig seitliche Ablaufbereich schließt unmittelbar an eine gemeinsame, vorzugsweise unmittelbar benachbart zu den Außenseiten der Flüssigkeitskühleinrichtung vorgesehene, Sammelkammer an, die direkt mit einem Ablaufanschluss, vorzugweise vorgesehen am zweiten Formkörper, verbunden ist.

Die erfinderische Lösung wird an Hand der Ausführungsbeispiele der Fig. 1 bis 4 weiter erläutert.

Fig. 1 zeigt eine erfindungsgemäße Anordnung in Explosionsdarstellung.

Fig. 2 zeigt einen zweiten Formkörper einer Flüssigkeitskühleinrichtung der Anordnung gemäß Fig. 1.

Fig. 3 zeigt einen ersten Formkörper einer Flüssigkeitskühleinrichtung der Anordnung gemäß Fig. 1.

Fig. 4 zeigt einen Schnitt durch die Anordnung gemäß Fig. 1.

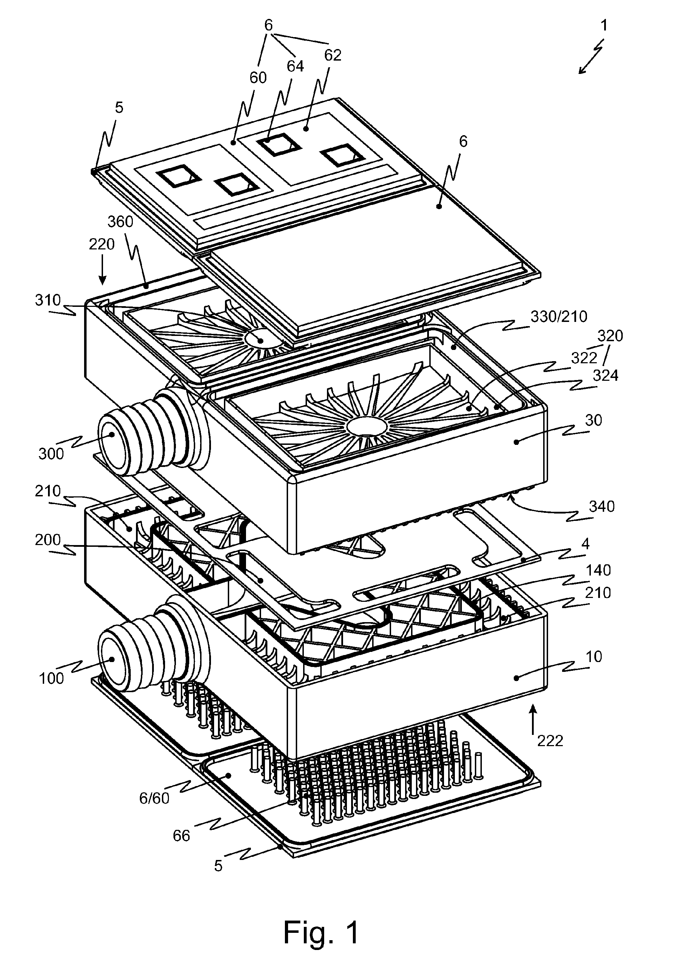

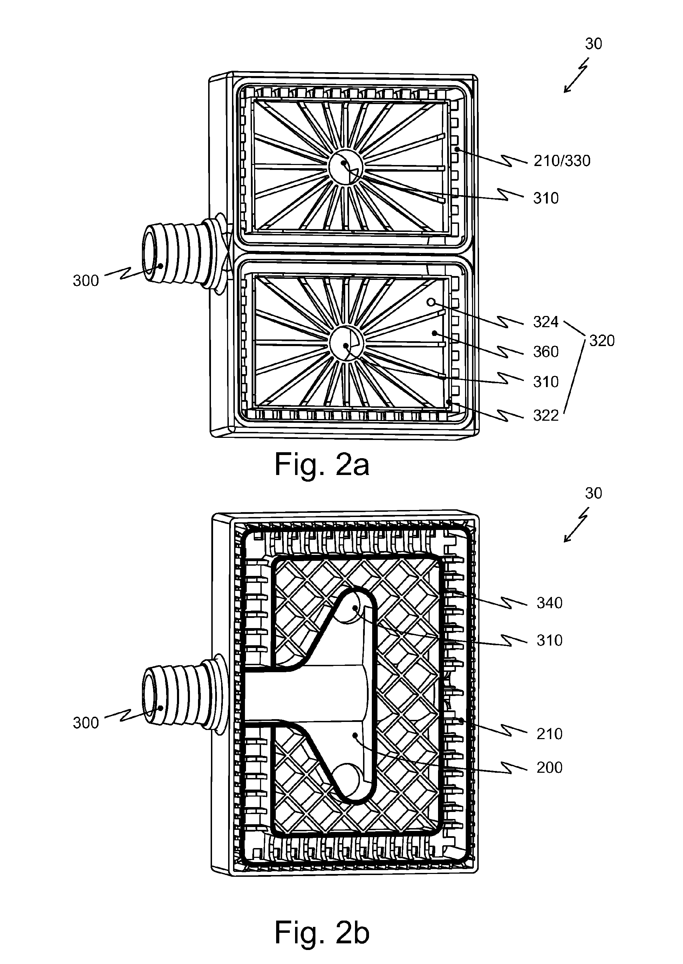

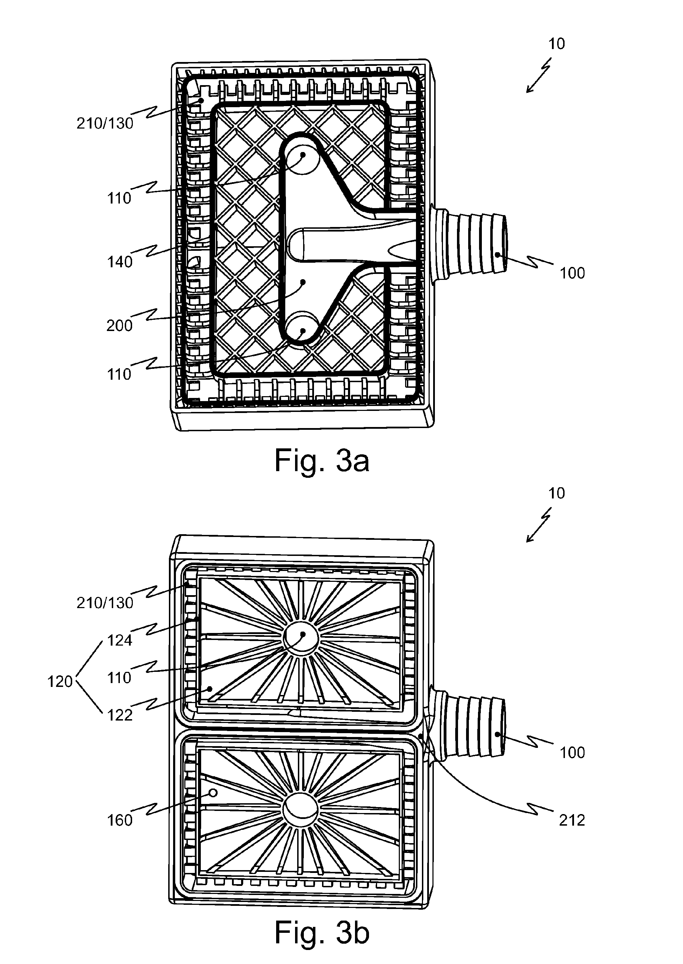

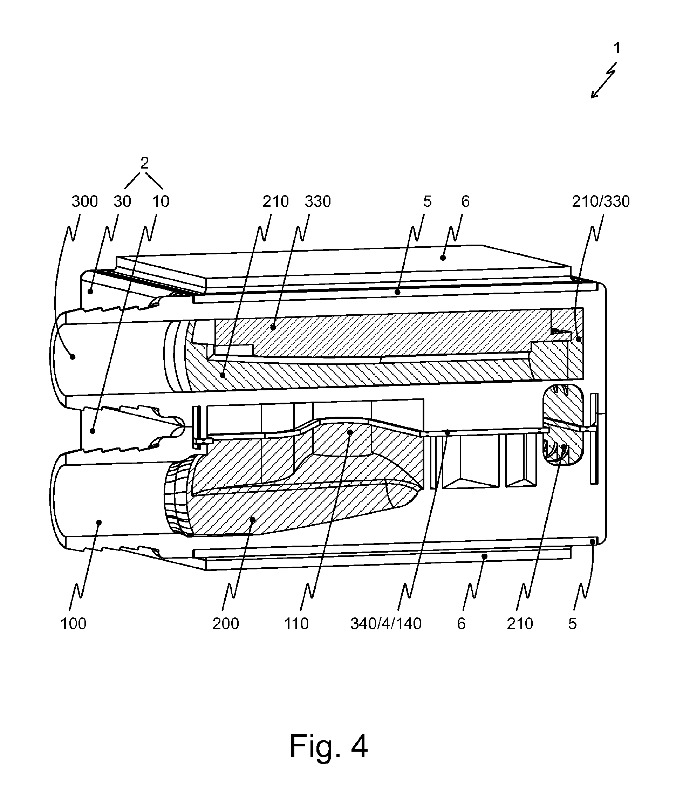

Die Fig. 1 zeigt eine erfindungsgemäße Anordnung (1) mit einer Mehrzahl von Leistungshalbleiterbaugruppen (6) und einer Flüssigkeitskühleinrichtung (2) in Explosionsdarstellung, wobei die Leistungshalbleiterbaugruppen (6) auf einander gegenüberliegenden Hauptseiten (220, 222) dieser Flüssigkeitskühleinrichtung (2) angeordnet sind. Die Fig. 4 zeigt einen Schnitt durch die Anordnung (1). Die Fig. 2 und 3 dienen der weiteren Verdeutlichung der Erfindung, indem sie Details der beiden Formkörper zeigen.

Jede der vier hier dargestellten Leistungshalbleiterbaugruppen (6) besteht aus einem Substrat (60), beispielhaft einem Metall- oder Keramiksubstrat. Auf dessen Oberseite, der ersten Hauptfläche sind gegeneinander isolierte Leiterbahnen (62) angeordnet, die teilweise Leistungshalbleiterbauelemente (64) tragen. Diese Leistungshalbleiterbauelemente (64) sind, nicht dargestellt, schaltungerecht miteinander, mit Leiterbahnen (62) und / oder ebenfalls nicht dargestellten aber grundsätzlich bekannten Anschlusselementen verbunden. Auf der, elektrisch von der Oberseite isolierten Unterseite, der zweiten Hauptfläche, können eine weitere metallische Schicht und alternativ oder zusätzlich Kühlmittel (66) angeordnet sein. Derartige Kühlmittel (66) können als Kühlstifte, wie dargestellt, oder auch Kühlfinnen die vom Zentrum radial nach außen verlaufen, ausgebildet sein. Diese Kühlmittel (66) dienen der weiteren Verbesserung des Wärmeübergangs vom Substrat (60) auf eine Kühlflüssigkeit.

Die im Wesentlichen quaderförmig ausgebildete Flüssigkeitskühleinrichtung (2) besteht aus zwei Formkörpern (10, 30), die die Flüssigkeitskühleinrichtung in zwei annähernd gleich große Hälften teilt. Details des zweiten Formkörper (30) sind in den Fig. 2a und 2b dargestellt, wobei Fig. 2a, die den Leistungshalbleiterbaugruppen (6) zugewandte Seite und Fig. 2 die dem ersten Formkörper (10) zugewandte Seite zeigen. Analog zeigt Fig. 3a den ersten Formkörper (10) mit seiner dem zweiten Formkörper (30) zugewandten Seite, während Fig. 3b die den Leistungshalbleiterbaugruppen (6) zugewandte Seite des ersten Formkörpers (10) zeigt.

Der Strömungsverlauf der Kühlflüssigkeit ist derart ausgebildet, dass diese Kühlflüssigkeit durch einen Zulauf (100) des ersten Formkörpers (10) in die Flüssigkeitskühleinrichtung (2) einströmt. Dieser Zulauf (100) geht in eine in beiden Formkörpern (10, 30) ausgebildete Verteilkammer (200) über. Von dieser Verteilkammer (200) fließt die Kühlflüssigkeit über Zuläufe (110, 310) zu den Kühlkammern (120, 320) der jeweiligen Formkörper (10, 30) und von dort über die Ablaufbereiche (130, 330) in eine beiden Formkörpern (10, 30) gemeinsame, Sammelkammer (210). Von dieser Sammelkammer (210) aus fließt die Kühlflüssigkeit durch den Ablaufanschluss (300) des zweiten Formkörpers (30) aus der Flüssigkeitskühleinrichtung (2) wieder heraus. Wesentlich hierbei ist, dass alle Kühlkammern (120, 320) die gleiche Menge an Kühlflüssigkeit und durch die Speisung aus einer gemeinsamen Verteilkammer (200) auch Kühlflüssigkeit gleicher Temperatur erhalten. Somit ist eine gleichmäßig effiziente Kühlung aller Leistungshalbleiterbaugruppen (6) gewährleistet.

Der Zulaufanschluss (100) der Flüssigkeitskühleinrichtung (2) ist an einer der Seitenwände des ersten Formkörpers (10) angeordnet. In dem ersten Formkörper (10) schließt sich an diesen Zulaufanschluss (100) derjenige Teil der Verteilkammer (200) an, der in dem ersten Formkörper ausgebildet ist. Von diesem Teil der Verteilkammer (200) reichen zwei Zuläufe (110) gleichen Durchmessers zu zwei Kühlkammern (120). Diese Kühlkammern (120) weisen je eine Grundfläche (122) auf in der der jeweilige Zulauf (110) mittig angeordnet ist. Den dieser Grundfläche (122) gegenüberliegenden Abschluss der Kühlkammer (120) bildet eine Leistungshalbleiterbaugruppe (6) mit ihrer Unterseite. Die Kühlkammer (120) bildet den wesentlichen Teil der Aufnahme (160) der Leistungshalbleiterbaugruppe (6) aus. Diese Aufnahme (160) besteht darüber hinaus noch aus dem Ablaufbereich (130) allseits um die Kühlkammer (120) angeordnet und aus einem Dichtbereich zur Anordnung einer zweiten Dichteinrichtung (5) zwischen Aufnahme (160) und Leistungshalbleiterbaugruppe (6).

Zwischen der Kühlkammer (120) und dem Ablaufbereich (130) ist weiterhin eine von der Grundfläche (122) aus in Richtung der Leistungshalbleiterbaugruppe (6) reichende Wandung (124) angeordnet ohne an dieser Leistungshalbleiterbaugruppe (6) anzuliegen. Somit wird an dieser Oberseite der Wandung (124) ein Überströmbereich von der Kühlkammer (120) zum Ablaufbereich (130) ausgebildet. Es kann vorteilhaft sein, diese Wandung (124) in ihrem Verlauf mit einer unterschiedlichen Höhe auszubilden, wodurch die Strömungsverhältnisse von dem Zulauf (110) zum Ablaufbereich (130) beeinflusst und damit optimiert werden können. Der Ablaufbereich (130) jeder Kühlkammer (120) geht direkt in denjenigen Teil der Sammelkammer (210) über, der sich umlaufend um den Randbereich in dem ersten Formkörper (10) erstreckt.

Der erste und zweite Formkörper (10, 30) weisen auf ihren einander zugewandten Seiten jeweils zueinander fluchtend eine Mehrzahl von Dichtflächen (140, 340) auf. Korrespondierende Dichtflächen (140, 340) dienen der Anordnung einer ersten Dichteinrichtung (4) zur Abdichtung der Verteilkammer (200) zur Sammelkammer (210), da sowohl die Verteilkammer, wie auch die Sammelkammer jeweils teilweise innerhalb beider Formkörper (10, 30) ausgebildet sind.

Der zweite Formkörper (30) weist ebenso wie der erste von seinem Teil der Verteilkammer (200) ausgehende jeweils wiederum gleichartig zueinander und zu denjenigen des ersten Formkörpers (10) ausgebildet Zuläufe (310) zu den beiden Kühlkammern (320) auf. Die jeweilige Kühlkammer bildet wiederum den wesentlichen Teil der Aufnahme (360) für eine Leistungshalbleiterbaugruppe (2) aus.

Diese Kühlkammern (320) sind ihrerseits identisch denjenigen des ersten Formkörpers (10) ausgebildet und weisen eine Grundfläche (322), eine diese begrenzende Wandung (324), die den Überströmbereich zum Ablaufbereich bildet, auf. Die Ablaufbereiche (330) des zweiten Formkörpers (30) sind ebenso identisch denjenigen des ersten Formkörpers (10) ausgebildet. Die Ablaufbereiche (130, 330) beider Formkörper (10, 30) gehen direkt in eine beiden Formkörpern (10, 30) gemeinsame Sammelkammer (210) über, die einen Endabschnitt (212) aufweist, der direkt in den Ablaufanschluss (300) übergeht. Dieser Ablaufanschluss (300) ist im zweiten Formkörper (30) seitlich, auf der gleichen Seite der Flüssigkeitskühleinrichtung (2), wie der Zulaufanschluss (100) im ersten Formkörper (10) angeordnet.

## Patentansprüche

1. Anordnung (1) mit einer Mehrzahl von Leistungshalbleiterbaugruppen (6) und einer Flüssigkeitskühleinrichtung (2), wobei die Leistungshalbleiterbaugruppen (6) auf einander gegenüberliegenden Hauptseiten (220, 222) dieser Flüssigkeitskühleinrichtung (2) angeordnet sind, und die Flüssigkeitskühleinrichtung (2) zwei Formkörper (10, 30) mit jeweils mindestens einer Aufnahme (160, 360) für die Leistungshalbleiterbaugruppen (6) aufweist
• mit einer beiden Formkörpern (10, 30) gemeinsamen Verteilkammer (200), deren Zulaufanschluss (100) im erste Formkörper (10) angeordnet ist;
• mit einer der jeweiligen Leistungshalbleiterbaugruppe (6) zugeordneten Kühlkammer (120, 320) mit einem Zulauf (110, 310) aus der Verteilkammer (200);
• mit je Kühlkammer (120, 320) seitlich hieran angeordneten Ablaufbereich (130, 330) und
• mit einer beiden Formkörpern (10, 30) gemeinsamen Sammelkammer (210) mit Ablaufanschluss (300).

2. Anordnung (1) nach Anspruch 1, wobei
die beiden Formkörper (10, 30) quaderförmig ausgebildet sind und miteinander eine gemeinsame Dichtfläche (140, 340) zur Anordnung einer Dichteinrichtung (4) aufweisen.

3. Anordnung (1) nach Anspruch 2, wobei
diese Dichtfläche (140, 340) mit angeordneter Dichteinrichtung (4) die Verteilkammer (200) von der Sammelkammer (210) trennen.

4. Anordnung (1) nach Anspruch 1, wobei
der Zu- (100) und der Ablaufanschluss (300) an der gleichen Außenseite der Flüssigkeitskühleinrichtung (2) angeordnet ist.

5. Anordnung (1) nach Anspruch 1, wobei
die Verteilkammer (200) im Wesentlichen mittig in der Flüssigkeitskühleinrichtung (2) angeordnet ist.

6. Anordnung (1) nach Anspruch 1, wobei
die Kühlkammer (120, 320) eine rechteckige Grundform aufweisen und die Zuläufe (110, 310) aus der Verteilkammer (200) mittig auf deren Grundfläche (322) angeordnet sind.

7. Anordnung (1) nach Anspruch 1, wobei
die Sammelkammer (210) unmittelbar benachbart zu den Außenseiten der Flüssigkeitskühleinrichtung (2) angeordnet ist.

8. Flüssigkeitskühleinrichtung (1) nach Anspruch 2, wobei
die Sammelkammer (210) und die Überströmbereiche (124, 324) direkt ineinander übergehen.

9. Anordnung (1) nach Anspruch 1, wobei
die jeweilige Leistungshalbleiterbaugruppe ein (6) direkt mit Kühlflüssigkeit in Kontakt stehendes Substrat (60) und auf der gegenüberliegenden Seite des Substrats (60) eine leistungselektronische Schaltung (62, 64) aufweist.
